# EUROPEAN PATENT APPLICATION

(11) **EP 4 718 158 A1**
(43) Date of publication of application: **01.04.2026**
(21) Application number: 24202976.7
(22) Date of filing: 26.09.2024
(51) Int. Cl.: G03F 7/20

(54) **METHOD TO PERFORM A SWEEPING MOTIONS IN MICROLITHOGRAPHY**

(71) Applicant: MYCRONIC AB, 183 03 Täby (SE)
(72) Inventor: Walther, Jonas, 169 37 Solna (SE)
(74) Representative: AWA Sweden AB

(57) **Abstract**

The present disclosure provides a method to perform a non-orthogonal sweeping motion in a microlithography system. The method comprises measuring a position deviation of the tool head relative the stage in a first direction parallel with the first axis, receiving a sweep command comprising a sweep angle, α, wherein the sweep angle is an angle between the sweep direction and the first direction, determining an X-offset in the scanning direction, based on the position deviation and the sweep angle, performing a first compensation of the sweeping motion of the optical beam scanning arrangement based on the position deviation and the sweep angle, performing a second compensation of the sweeping motion by moving the tool head and/or the stage in the scanning direction based on the X-offset, performing the sweeping motion in the sweep direction wherein the sweep direction is non-orthogonal to the first axis and the second axis, respectively.

## Description

### Technical field

The present disclosure relates generally to the field of optical microlithography. In particular, the present disclosure relates to a method to compensate for a non-orthogonal sweeping motion in a microlithography system.

### Background

In optical microlithography an optical beam is focused onto a substrate using projection optics, wherein a photo-sensitive resist provided on the substrate may be exposed to the beam. A microlithography system can expose different regions of the substrate to the optical beam, thereby writing a pattern. Optical microlithography can create very small patterns, down to nanometer size, and provide a precise control of the design of the pattern. Typically, the substrate is arranged in a coordinate system having an X-axis and a Y-axis. The microlithography system may sweep the optical beam may in a direction parallel to the Y-axis while moving along a mechanical scanning direction parallel to the X-axis.

However, as semiconductor technology advances, the demand for smaller, more powerful, and more energy-efficient devices grows. This requires patterning extremely small features on wafers, often at scales of micrometers and nanometers. The global demand for electronic devices continues to rise, leading to higher production volumes in semiconductor manufacturing. To meet this demand, manufacturers must process wafers more quickly while maintaining or improving pattern accuracy. Precision in microlithography minimizes the need for rework and reduces the occurrence of defects, both of which can be costly. Improving the accuracy of lithography processes helps to lower the overall cost of production. Time-efficient systems also contribute to cost reduction by speeding up the manufacturing process, which can decrease operational costs and improve the utilization of expensive fabrication equipment.

Hence, there is still a need to optimize the writing process of a microlithography system.

### Summary

One general aim of the present disclosure is to provide an improved microlithography method and microlithography system. Specifically, there is a desire to be able to perform non-orthogonal sweeping motions in the writing process of a microlithography system .

This and other objects are achieved by means of a method and a system as defined in the appended independent claim(s). Other embodiments are defined by the dependent claims.

According to a first aspect of the present disclosure, a method to perform a non-orthogonal sweeping motion in a microlithography system is provided. The microlithography system is configured to write a pattern on a substrate arranged in a plane defined by a first axis and a second axis. The second axis is orthogonal to the first axis. The microlithography system comprises a stage configured to support the substrate. The microlithography system comprises a tool head comprising an optical beam scanning arrangement configured to direct an optical beam in a sweeping motion in a sweep direction. The tool head and/or the stage is movable to provide relative motion between the tool head and the stage in a scanning direction parallel with the second axis. The method comprises measuring a position deviation of the tool head relative the stage in a first direction parallel with the first axis. The method comprises receiving a sweep command comprising a sweep angle, α. The sweep angle is an angle between the sweep direction and the first direction. The method comprises determining an X-offset in the scanning direction, based on the position deviation and the sweep angle. The method comprises performing a first compensation of the sweeping motion of the optical beam scanning arrangement based on the position deviation and the sweep angle. The method comprises performing a second compensation of the sweeping motion by moving the tool head and/or the stage in the scanning direction based on the X-offset. The method comprises performing the sweeping motion in the sweep direction. The sweep direction is non-orthogonal to the first axis and the second axis, respectively.

The present disclosure relates to the idea of providing a method to perform a non-orthogonal sweeping motion in a microlithography system that may provide increased accuracy and reliability within optical microlithography by providing a new way of performing non-orthogonal sweeping motions. The present disclosure also relates to the idea of providing a writing method that is both time efficient and provides accurate pattern generation and positioning of a non-orthogonal sweeping motion in a microlithography system. The method to compensate for a non-orthogonal sweeping motion may be employed in devices and systems wherein optical microlithography is used.

Optical microlithography is a technique in which an optical beam, i.e. light, is used to generate a pattern on/in a substrate. The substrate may be provided with a thin coating of suitable material, such as a photo-sensitive resist. Thereby, a pattern may be formed as different regions of the photo-sensitive resist is exposed to the optical beam. A writing process using optical microlithography may create features in the micrometer range and/or nanometer range. A microlithography system may be a nanolithography system, and may be understood to include microlithography systems for scales/features both in the micrometer and the nanometer range. A nanolithography system may be capable of writing nanoscale patterns on a substrate, such as patterns having features smaller than 100 nm. A microlithography system may be a system and/or a device using optical microlithography to produce a patterned substrate. Such a system may for example be a pattern generator or a mask writer.

The substrate may comprise a flat surface, sheet and/or a plate, such as, a plate made of glass, Quartz or Soda-lime glass. The substrate may comprise at least one coating or layer, such as a photo-sensitive resist and/or a chrome layer. It is to be understood that the substrate may be any substrate present when writing in a microlithography system. For example, a substrate may refer to a glass (or Quartz) substrate provided with a chrome layer and/or photo-sensitive resist layer, and/or it may refer to a substrate in a direct writing microlithography system, i.e. maskless writing microlithography.

The substrate is arranged (or placed/positioned) in a plane defined by a first axis and a second axis. The first axis and the second axis may define (or span) a writing coordinate system or a writing plane. The substrate may be arranged in the writing coordinate system or the writing plane. The substrate may be arranged (placed/positioned) on or in the stage. The stage may be configured to support (or receive/arrange) the substrate in the writing coordinate system. The stage may be a platform, a holder, and/or an attachment unit configured to support the substrate. The stage may be movably arranged in the microlithography system. The stage may be configured to move in the writing coordinate system, i.e., in the first direction and/or in the scanning direction.

The tool head may be arranged in the microlithography system such that the tool head may direct (or project) an optical beam onto the substrate. The tool head may be arranged (defined) in the writing coordinate system. The tool head may comprise projection optics, i.e., one or more optical components (or elements) configured to project (or direct/focus) an optical beam onto the substrate. As the optical beam is directed onto the substrate, a pattern may be created. In other words, the microlithography system may write a pattern on the substrate. The tool head may also be referred to herein as "writing head" or "optical head".

The optical beam scanning arrangement comprised in the tool head is configured to direct (or deflect/sweep/scan) an optical beam onto the substrate in a sweeping motion in a sweep direction. Directing the optical beam in a sweeping motion in the sweep direction may constitute performing (or carrying out/executing/completing) a sweep. A sweep may be referred to herein as a "microsweep". The sweep direction may be a direction along which the sweeping motion is performed and/or a direction along which a sweep is performed. The sweep direction may be defined in the writing coordinate system and/or in the writing plane. The sweep direction is non-orthogonal to the first axis and the second axis, respectively. Thus, the sweep direction is not aligned (nor parallel) with the first axis and the second axis, respectively. A sweeping motion performed in (or along) the non-orthogonal sweep direction may be referred to herein as a "non-orthogonal sweeping motion". The sweeping motion may be defined as the movement of the optical beam in the sweep direction when directed by the optical beam scanning arrangement.

The microlithography system may generate a pattern on a substrate. The pattern may divided in a plurality of pixels having a predetermined pixel size. The pixel size may vary depending on application or the type of pattern to be generated. The pattern may be stored (or represented) in data points, wherein each data point correspond to one pixel. A microsweep may correspond to (or comprise) a predetermined number of pixels of the plurality of pixels. Thus, performing a plurality of microsweeps may generate (or create) a complete pattern on a substrate. Directing an optical beam onto a substrate in a sweeping motion may comprise directing a plurality of individual optical beams in a sweeping motion onto a substrate. Depending on activation of the individual optical beams, a pattern may be generated. Thus, an executed microsweep may generate a part of the pattern created by activation and/or deactivation of the plurality of individual optical beams.

The optical beam scanning arrangement may comprise one or more optical components (or elements), such as lenses, filters, windows, optical flats, prisms, polarizers, beam-splitters, wave-plates, crystals, optical polygons, fiber optics, and/or mirrors. The optical beam scanning arrangement may be configured to receive input (or data), e.g., input related to the sweeping motion. For example, the optical beam scanning arrangement may receive input related to the sweep angle and/or one or more properties of the sweeping motion. The optical beam scanning arrangement may direct an optical beam in the sweep direction, i.e., at a sweep angle, α, from the first direction. The optical beam scanning arrangement may configured to direct an optical beam in a sweeping motion in a sweep direction based on the received input.

The tool head may be movably arranged in the microlithography system. The tool head may be configured to move in the writing coordinate system, i.e., in the first direction and/or in the scanning direction. The tool head and the stage may be movable relative each other, e.g., in the scanning direction. The tool head and the stage may be arranged in the microlithography system in order to provide relative motion between the tool head and the stage in the scanning direction. The microlithography system may be configured to perform one or more sweeping motions (and thus, one or more microsweeps) along the scanning direction.

The method comprises measuring (or determining/detecting) a position deviation of the tool head relative the stage in the first direction. The method may comprise measuring a position of the tool head and/or the stage. A position deviation of the tool head relative the stage in the first direction may occur due to, e.g., vibrations or measurement errors in a positioning system of the microlithography system. The positioning system of the microlithography system may be configured to measure (or determine) positions, or relative positions, of the components of the microlithography system. The positioning system may be configured to measure a position deviation of the tool head relative the stage in the first direction.

The method comprises receiving a sweep command comprising a sweep angle, α. The sweep angle is an angle between the sweep direction and the first direction. By this, the optical beam scanning arrangement may direct an optical beam in a sweeping motion at an angle, i.e., the sweep angle, to the first direction. The sweep command may be received by a control unit, a processing unit, or the like, comprised in, or externally arranged to, the microlithography system. The sweep command may be generated based on, for example, input from a user (or operator) of the microlithography system. The sweep angle may be set by a user or be pre-set (or predetermined) in the microlithography system, e.g., in a control unit.

The method comprises determining an X-offset in the scanning direction. The microlithography system may comprise a control unit configured to determine (or calculate) the X-offset. The X-offset is determined based on the position deviation and the sweep angle, α. The control unit may be configured to store data (or input), such as the X-offset, the position deviation, and/or the sweep angle. The X-offset is defined in the scanning direction.

The compensation for a non-orthogonal sweeping motion in the microlithography system may comprise a first compensation in the sweep direction and a second compensation in the scanning direction. The first compensation of the sweeping motion may be applied (or adjusted/performed) in the optical beam scanning arrangement in (or along) the sweep direction. The first compensation is based on the position deviation and the sweep angle, α. In an example, a sweep deviation may be determined (or calculated), e.g., in the control unit, based on the measured position deviation and the sweep angle. The calculated sweep deviation may be applied to the optical beam scanning arrangement to perform the first compensation of the sweeping motion in the sweep direction. The calculated sweep deviation may correspond to (or represent) a length that the sweeping motion may be adjusted or moved in the sweep direction. The second compensation of the sweeping motion may be applied by moving the tool head and/or the stage in (or along) the scanning direction. The second compensation is based on the determined X-offset. In an example, the X-offset may correspond to (or represent) a length that the sweeping motion may be adjusted or moved in the scanning direction. After or simultaneously as performing (or applying) the first compensation and/or the second compensation, the sweeping motion in the sweep direction may be performed by the microlithography system.

The method according to the first aspect of the present disclosure may provide a more efficient, e.g. in terms of time, and more accurate compensation for a non-orthogonal sweeping motion during writing in a microlithography system. The method comprises performing a first compensation along the sweeping direction and a second compensation along the scanning direction. In this way, a more accurate and correct compensation may be achieved in the respective directions. The compensation divided into two components (or corrections) in the respective directions allows for a smooth and fast compensation in the microlithography system in real time. The first and second compensations may be performed simultaneously during a writing process and in-situ in the microlithography system based on data generated in real time. The combination of the two corrections will generate a correct positioning of the sweeping motion (and thus, the microsweep) in the writing plane, i.e., correct positioning in the first direction and the scanning direction.

Furthermore, the method according to the first aspect of the present disclosure may provide an improved writing process to generate a pattern on a substrate, specifically wherein the writing process comprises one or more non-orthogonal sweeping motions. The method according to the first aspect of the present disclosure allows for an efficient and high-quality generation of a pattern on a substrate.

According to some embodiments, the microlithography system may further comprise at least one position sensor. The at least one position sensor may be configured to measure a position deviation of the tool head relative the stage in the first direction. The method may further comprise receiving the position deviation from the at least one position sensor.

The at least one position sensor may be configured to measure (or determine/detect) a position of a component of the microlithography system, such as the tool head and/or the stage. The at least one position sensor may be configured to perform measurements in the writing coordinate system. For example, the at least one position sensor may perform measurements along (or in) a direction parallel with the first axis and/or a direction parallel with the second axis. The at least one position sensor may form part of the positioning system of the microlithography system. The step of measuring a position deviation of the tool head relative the stage in the first direction may be performed by the at least one position sensor. The at least one position sensor may be configured to generate data relating to a position, and/or a position deviation, of the tool head and/or the stage in the writing coordinate system. The position sensor may be connected, by cable or wirelessly, to one or more components of the microlithography system. In an example, a control unit of the microlithography system may be configured to receive data, such as a measured position deviation, from the at least one position sensor. During a writing process, the at least one position sensor may measure a position deviation of the tool head relative the stage in the first direction and communicate, in real time, the measured position deviation to the control unit. The control unit may thereby, in real time during a writing process, perform, e.g., calculations based on the measured position deviation. In this way the first compensation and the second compensation may be better performed in real time during a writing process.

The at least one position sensor may provide accurate and reliable measurements related to the a position deviation of the tool head relative the stage in the first direction in real time. This in turn may provide accurate and reliable compensations of the sweeping motion in the sweep direction and the scanning direction, respectively.

According to some embodiments, the at least one position sensor may comprise an interferometer.

An interferometer may be any device that extract information from interference, here in order to measure a position deviation of the tool head relative the stage in a first direction. Using an interferometer may provide improved precision and accuracy in determining a position, and/or a position deviation of the tool head and/or the stage in the writing coordinate system. By extension, this may provide an improved accuracy of further calculations related to the first and second compensations for a non-orthogonal sweeping motion.

According to some embodiments, the optical beam scanning arrangement may comprise at least one mirror, at least one optical polygon, and/or at least one prism.

The optical beam scanning arrangement may comprise at least one mirror, at least one optical polygon, and/or at least one prism to direct an optical beam in a sweeping motion in a sweep direction onto the substrate. The at least one mirror, the at least one optical polygon, and/or the at least one prism may be movable. In an example, a mirror comprised in the optical beam scanning arrangement may be movably (or rotatably) arranged such that a sweeping motion (or a sweep/scan) of the optical beam onto the substrate may be performed. The mirror may move, e.g., wiggle or be angled, such that the optical beam is moved in a sweeping motion and, thus, a sweep is performed. In an example, an optical polygon comprised in the optical beam scanning arrangement may be movably (or rotatably) arranged. The optical polygon may be rotated such that a sweeping motion (or a sweep/scan) of the optical beam onto the substrate may be performed. In an example, a prism may be movably (or rotatably) arranged in the optical beam scanning arrangement such that a sweeping motion (or a sweep/scan) of the optical beam onto the substrate may be performed by moving the prism. A combination of at least one mirror, at least one optical polygon, and/or at least one prism may be arranged to direct an optical beam in a sweeping motion in a sweep direction. The optical beam scanning arrangement may comprise a control unit, an actuator, or the like, configured to actuate a movement of the at least one mirror, the at least one optical polygon, and/or the at least one prism. The control unit of the optical scanning arrangement may receive input, e.g., related to one or more properties of the sweeping motion, such as the sweep angle. The control unit may control the movement of the at least one mirror, the at least one optical polygon, and/or the at least one prism based on the received input.

According to some embodiments, the optical beam scanning arrangement may comprise an acousto-optical deflector.

The acousto-optical deflector may be configured to direct (or deflect) the optical beam in a sweeping motion in a sweep direction onto the substrate. The acousto-optical deflector may be configured to execute one or more microsweeps onto the substrate. The acousto-optical deflector may be configured to receive input (or data), such as input for controlling the deflection of the optical beam. For example, the input may comprise one or more parameters used to control an output optical beam of (or from) the acousto-optical deflector. The one or more parameters may control one or more properties of the sweeping motion of the optical beam. The input to the acousto-optical deflector may comprise sound waves.

The acousto-optical deflector may direct an optical beam in a sweeping motion in an efficient and controlled way. The properties of a sweeping motion of the optical beam may be easily and accurately controlled by adjusting the input to the acousto-optical deflector.

The acousto-optic deflector (AOD) is a device that uses the interaction between sound waves and light waves to deflect or redirect a laser beam. AODs are practically the same as acousto-optic modulators (AOMs).

According to some embodiments, performing a first compensation of the sweeping motion of the optical beam scanning arrangement may comprise adjusting an input signal to the acousto-optical deflector based on the position deviation and the sweep angle such that the sweeping motion may be controlled at least partially based on the input signal.

The acousto-optical deflector may receive an input signal, e.g., from a control unit comprised in the microlithography system. The input signal may indicate an adjustment (or correction/compensation) of the sweeping motion of the optical beam. The input signal may be based on a measured position deviation, e.g., by the at least one position sensor, and a sweep angle comprised in a sweep command. In an example, a sweep deviation may be determined, e.g., in a control unit, based on the measured position deviation and the sweep angle. The sweep deviation may be communicated to the acousto-optical deflector via the input signal. The sweeping motion may be controlled based on the sweep deviation and the first compensation may be performed. The acousto-optical deflector may receive the input signal continuously in real time during a writing process, which allows for continuous control (or adjustment) of the sweeping motion. By this, the sweeping motion may be efficiently controlled continuously during a writing process based on, e.g., a continuously measured position deviation and a received sweep command.

According to some embodiments, adjusting the input signal may comprise adjusting at least one of an acoustic frequency and an acoustic amplitude of the acousto-optical deflector based on the position deviation and the sweep angle.

The acousto-optical deflector may be controlled by the acoustic frequency and/or the acoustic amplitude. The input signal may comprise one or more parameters, such as the acoustic frequency and the acoustic amplitude. The input signal may control an output optical beam of the acousto-optical deflector. The acousto-optical deflector may receive an optical beam, also referred to as an input optical beam or an incident optical beam to the acousto-optical deflector. The output optical beam of the acousto-optical deflector, also referred to as the deflected (or directed) optical beam, may be the outgoing optical beam from the acousto-optical deflector. In an example, the acousto-optical deflector may receive an input optical beam, which may be deflected based on one or more parameters of the input signal, and exits the acousto-optical deflector as an output optical beam.

The input signal to the acousto-optical deflector may control the sweeping motion of the optical beam, that is, e.g., how the optical beam is directed (or deflected). The acoustic frequency may control the deflection of the optical beam. The angle of the output beam from the acousto-optical deflector may be proportional to the acoustic frequency. By varying the acoustic frequency, the optical beam may be deflected to different angular positions. The acoustic frequency may thus control the movement of the optical beam in the sweeping motion. In an example, the acoustic frequency of the acousto-optical deflector may be changed (or adjusted/varied), e.g., within a range or interval, thereby causing the output optical beam to move. The output optical beam may move in a sweeping motion in the sweep direction, e.g., a distance corresponding to the acoustic frequency range.

The acoustic amplitude may control the intensity of the optical beam. For example, the intensity of the first order output optical beam may be proportional to the acoustic amplitude. By varying the acoustic amplitude, the intensity of the optical beam may be varied. In an example, the acoustic amplitude of the acousto-optical deflector may be changed (or adjusted/varied), thereby causing the intensity of the output optical beam to change. This may, for example, allow for adjustment of the size of a microsweep. The present embodiment is advantageous in that the adjustment of the input signal may be performed in a more precise and versatile manner, thereby improving the non-orthogonal sweeping motion and consequently improving the production and/or result of the patterned substrate.

Based on the measured position deviation and the sweep angle, the acoustic frequency and/or the acoustic amplitude may be adjusted (or changed). In this way, a measured position deviation may control the sweeping motion of the optical beam via the acoustic frequency and/or the acoustic amplitude. Likewise, a sweep angle of a sweep command may control the sweeping motion of the optical beam via the acoustic frequency and/or the acoustic amplitude.

According to some embodiments, a speed of the sweeping motion in the sweeping direction may be kept constant.

The sweeping motion of the optical beam may move with a constant speed onto the substrate. The optical beam may be directed (or deflected) by the optical beam scanning arrangement such that the optical beam may move (or sweep/scan) over the substrate at a constant speed. The speed of the sweeping motion may be kept constant in order to provide a correctly performed microsweep. By the formulation "is kept constant" it may mean that a speed of the sweeping motion in the sweeping direction is controlled towards a predetermined constant value, e.g. a control unit may be configured to control the speed of the sweeping motion towards the predetermined constant value.

In an example, the microlithography system may write a pattern on the substrate, wherein the pattern may comprise a plurality of microsweeps. The pattern data may be clocked at a certain frequency, wherein a constant speed of the sweeping motion may provide correct positioning of each of the plurality of microsweeps, and thus, a correctly generated (or written) pattern.

A constant speed of the sweeping motion in the sweep direction may correspond to a constant movement and/or rotation of the at least one mirror, the at least one optical polygon, and/or the at least one prism, if the sweeping motion direction is constant. The speed of the sweeping motion may thus be controlled by the movement and/or the rotation of the at least one mirror, the at least one optical polygon, and/or the at least one prism.

A constant speed of the sweeping motion in the sweep direction may correspond to a linear (or constant) angular change of the output optical beam of the acousto-optical deflector. The speed of the sweeping motion may thus be controlled by the acoustic frequency and/or the acoustic amplitude. Thereby, the acoustic frequency and/or the acoustic amplitude may provide efficient modulation of one or more properties of the sweeping motion of the optical beam in the sweep direction.

According to some embodiments, a length of the sweeping motion in the sweeping direction may be predetermined.

A sweeping motion of the optical beam onto the substrate has a length defined by the angular range of motion of the sweep and the distance to the substrate. The length of a sweeping motion (and thus, of a microsweep) may be predetermined (or pre-set/pre-calibrated) in the microlithography system, e.g., in a control unit of the microlithography system. The length of the sweeping motion may be based on a pixel size and/or a pattern to be generated on the substrate. The length of the sweeping motion may be defined in the writing plane. A sweeping motion may have a predetermined start position in the writing plane. In an example, a start position of a sweeping motion may be an X-coordinate (of the second axis) in the writing plane. A sweeping motion of the optical beam may start at that X-coordinate and move a distance corresponding to the length of the sweeping motion in the sweep direction. The present embodiment is advantageous in that the non-orthogonal sweeping motion may be performed in a more consistent and efficient manner, thereby improving the non-orthogonal sweeping motion and consequently improving the production and/or result of the patterned substrate.

According to some embodiments, the method may further comprise moving the tool head and/or the stage with a constant velocity in the scanning direction.

During a writing process, the tool head and/or the stage may be moved relative each other. Thereby, the substrate and the tool head may be moved relative each other. By moving the tool head and/or the stage in the scanning direction one or more sweeping motions may be performed in the scanning direction. The microlithography system may comprise a control unit, an actuator, a servo unit, or the like, configured to provide relative motion between the tool head and the stage in the scanning direction. In an example, a servo unit of the microlithography system may drive/move the tool head and/or the stage with a constant velocity in the scanning direction. The second compensation may be performed based on a determined X-offset and the constant velocity of the tool head and/or the stage in the scanning direction.

In an example, the at least one position sensor of the microlithography system may be configured to measure a relative position of the tool head and the stage in the scanning direction. The at least one position sensor may generate data related to a measured relative position of the tool head and the stage in the scanning direction. The servo unit may for example receive data from the at least one position sensor. The relative movement between the tool head and the stage in the scanning direction actuated by the servo unit may be based on received data from the at least one position sensor.

The present embodiment is advantageous in that the non-orthogonal sweeping motion may be performed in a more consistent and efficient manner, thereby improving the non-orthogonal sweeping motion and consequently improving the production and/or result of the patterned substrate.

According to some embodiments, the X-offset may correspond to a time delay. A start of the sweeping motion may be based on the time delay.

As the tool head and/or the stage may be moved in the scanning direction, a determined X-offset in the scanning direction may correspond to a time delay based on the velocity of the movement. Based on a determined X-offset and a velocity of the tool head and/or the stage in the scanning direction, a time delay may be determined (or calculated). The calculated time delay may determine a start of a sweeping motion of the optical beam onto the substrate. In an example, a start position of a sweeping motion may be an X-coordinate (of the second axis) in the writing plane. The start position may be based on a determined X-offset, and thus, on a time delay given the velocity of the tool head and/or stage.

In an example, a sweeping motion may have a start position indicated by a first X-coordinate of the second axis. Based on an X-offset in the scanning direction, determined based on a measured position deviation and a sweep angle, the start position may be moved (or changed/adjusted) to a second X-coordinate of the second axis. Given that the tool head and/or the stage moves in the scanning direction with a certain velocity, the second compensation may be performed with the X-offset corresponding to a time delay. Thus, performing a sweeping motion may be at least partly triggered by time. The present embodiment is advantageous in that the non-orthogonal sweeping motion may be performed in a more controlled manner while providing a more efficient way of compensating for the non-orthogonal sweeping motion in the scanning direction, thereby improving the non-orthogonal sweeping motion, e.g. in terms of precision, and consequently improving the production and/or result of the patterned substrate.

According to some embodiments, the sweep angle, α, may be 45 degrees.

If the sweep angle is 45 degrees, the position deviation may be equal to the X-offset. This may provide facilitated and more efficient calculations regarding the first compensation and the second compensation.

According to some embodiments, the sweep angle, α, may fulfill 0° < α < 90°.

The sweep angle, i.e., the angle between the sweep direction and the first direction, may thus be greater than 0 degrees and less than 90 degrees. This may provide a sweeping motion of the optical beam that may be non-orthogonal to the first axis and the second axis, respectively. By this, a sweeping motion may be performed in a sweep direction at a sweep angle greater than 0 degrees and less than 90 degrees from the first direction. The present embodiment is advantageous in that the non-orthogonal sweeping motion may be performed in a more advantageous manner, e.g. in terms of resulting quality of the patterned substrate.

According to a second aspect of the present disclosure, a microlithography system configured to write a non-orthogonal sweeping motion on a substrate is provided. The substrate is arranged in a plane defined by a first axis and a second axis, wherein the second axis is orthogonal to the first axis. The microlithography system comprises a stage configured to support the substrate. The microlithography system comprises a tool head comprising an optical beam scanning arrangement configured to direct an optical beam in a sweeping motion in a sweep direction. The tool head and/or the stage is movable to provide relative motion between the tool head and the stage in a scanning direction parallel with the second axis. The microlithography system comprises at least one position sensor configured to measure a position deviation of the tool head relative the stage in a first direction parallel with the first axis. The microlithography system comprises a control unit configured to receive a sweep command comprising a sweep angle, α. The sweep angle is an angle between the sweep direction and the first direction. The control unit is configured to determine an X-offset in the scanning direction based on the position deviation and the sweep angle. The control unit is configured to control the optical beam scanning arrangement by applying a first compensation based on the position deviation and the sweep angle. The control unit is configured to control the movement of the tool head and/or the stage by applying a second compensation based on the X-offset. The control unit is configured to control a sweeping motion in the sweep direction. The sweep direction is non-orthogonal to the first axis and the second axis, respectively.

The present disclosure, according to this second aspect, relates to an improved microlithography system configured to write a pattern on a substrate It will be appreciated that any features, advantages or further explanations provided in more detail in relation to the method to compensate for non-orthogonal sweeping motion according to the first aspect of the present disclosure may also apply mutatis mutandis to the microlithography system according to the second aspect of the present disclosure.

The microlithography system according to the second aspect may be configured to perform the method according the first aspect of the present invention.

According to some embodiments, the microlithography system may be configured to perform a plurality of sweeping motions in sequence, wherein the plurality of sweeping motions may comprise at least one non-orthogonal sweeping motion.

The microlithography system may be configured to perform a plurality of sweeping motions in sequence such that a pattern is generated on the substrate. In an example, the microlithography system may be configured to perform one or more sweeping motions in the scanning direction. For example, performing a sweeping motion may be triggered by a relative position between the tool head and the stage in the scanning direction. The plurality of sweeping motions may be a combination of non-orthogonal sweeping motions and sweeping motions in a sweep direction parallel with the first axis.

By performing a plurality of sweeping motions in sequence, a complete pattern may be generated on a substrate. Combining non-orthogonal and orthogonal sweeping motions may provide an improved versatility of the microlithography system and an improved efficiency for certain types of patterns.

It is noted that other embodiments using all possible combinations of features recited in the above-described embodiments may be envisaged. Thus, the present disclosure also relates to all possible combinations of features mentioned herein.

### Brief description of drawings

Exemplifying embodiments will now be described in more detail, with reference to the following appended drawings:
Figure 1A schematically illustrates a microlithography system according to some embodiments of the present disclosure;
Figure 1B schematically illustrates a microlithography system according to some embodiments of the present disclosure;
Figure 2A schematically illustrates an example of a sweeping motion performed by an optical beam scanning arrangement according to some embodiments of the present disclosure;
Figure 2B schematically illustrates an example of a sweeping motion performed by an optical beam scanning arrangement according to some embodiments of the present disclosure;
Figure 3 illustrates a flow diagram of a method to compensate for a non-orthogonal sweeping motion according to some embodiments of the present disclosure;
Figure 4 schematically illustrates a compensation for a non-orthogonal sweeping motion according to some embodiments of the present disclosure;
Figure 5 schematically illustrates an example of a writing process of a substrate comprising a non-orthogonal sweeping motion according to some embodiments of the present disclosure.

As illustrated in the figures, the sizes of the elements and regions may be exaggerated for illustrative purposes and, thus, are provided to illustrate the general structures of the embodiments. Like reference numerals refer to like elements throughout.

### Detailed description

Exemplifying embodiments will now be described more fully hereinafter with reference to the accompanying drawings in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

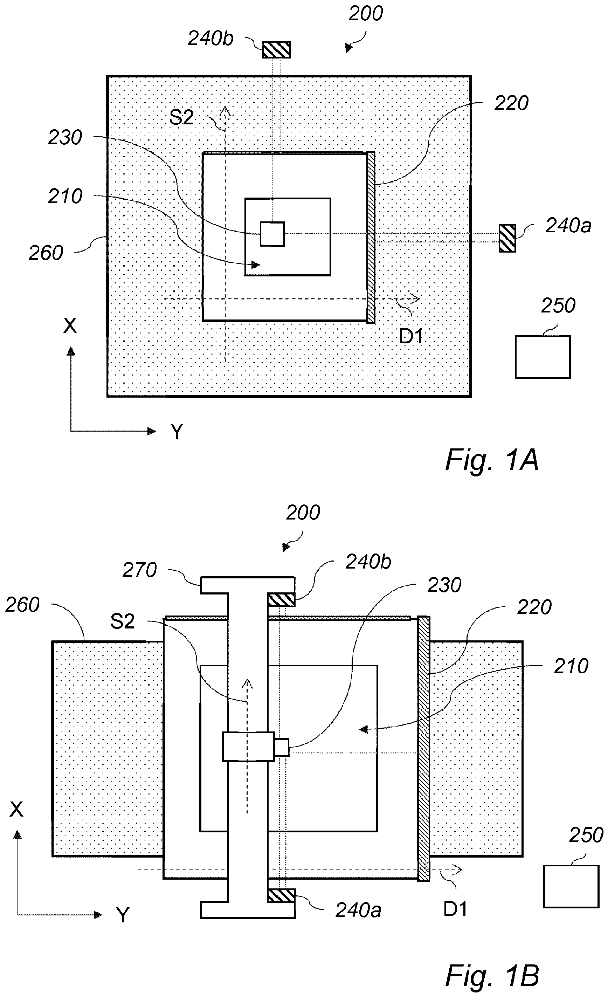

Figs. 1A and 1B schematically illustrates examples of microlithography systems in accordance with a second aspect of the present disclosure.

In Fig. 1A, a schematic illustration of a microlithography system 200 configured to write a pattern on a substrate 210, in accordance with a second aspect of the present disclosure, is shown in top view. The substrate 210 is arranged in a plane defined by a first axis Y and a second axis X. The first axis Y and second axis X are orthogonal and spans a writing coordinate system.

The microlithography system 200 comprises a stage 220 configured to support the substrate 210. The substrate 210 is arranged on the stage 220 in the writing coordinate system. In Fig. 1A, the stage 220 is illustrated as a platform or a plate, however, the stage 220 may be formed differently, e.g., as a holder. In Fig. 1A, the stage is movable in a direction parallel with the first axis Y, e.g., a first direction D1, and in a direction parallel with the second axis X, e.g., a scanning direction S2. The microlithography system 200 in Fig. 1A comprises a tool head 230 which has a fixed position in the writing coordinate system. In Fig. 1A, a relative motion between the tool head 230 and the stage 220 in the scanning direction S2 is provided. Likewise, a relative motion between the tool head 230 and the stage 220 in the first direction D1 is provided.

The tool head 230 comprises an optical beam scanning arrangement (not shown) configured to direct an optical beam (not shown) onto the substrate 210. The substrate 210 may be provided with a thin coating of a photo-sensitive resist, and as the photo-sensitive resist is exposed to the optical beam a pattern may be formed. Such a process may be referred to herein as a microlithography writing process, or simply a writing process. During a writing process, the stage 220 in Fig. 1A may move along the scanning direction S2 and along the first direction D1, such that different parts of the substrate 210 may be exposed to the optical beam, and thus, a pattern may be created. In an example, during a writing process the stage 220 may move to a first predetermined position along the first direction D1 and then, at that first predetermined position along the first direction D1, move along the scanning direction S2 while writing. The stage 220 may move to a second predetermined position along the first direction D1 and at that second predetermined position along the first direction D1, move along the scanning direction S2 while writing. This may be repeated until a complete pattern is written on the substrate 210.

In Fig. 1A, the microlithography system 200 comprises a first position sensor 240a and a second position sensor 240b. The first position sensor 240a is configured to measure a position, and/or a position deviation, of the tool head 230 relative the stage 220 in the first direction D1, as illustrated with the dotted lines in Fig. 1A. The second position sensor 240b is configured to measure a position of the tool head 230 relative the stage 220 in the scanning direction S2, as illustrated with the dotted lines in Fig. 1A. In an example, the first position sensor 240a and/or the second position sensor 240b may be interferometers and the dotted lines illustrated in Fig. 1A may represent light (or electromagnetic waves), e.g., from a coherent light source such as a laser source. The microlithography system 200 comprises a base stone 260, as seen in Fig. 1A, on which the stage 220 may be arranged.

As shown in Fig. 1A, the microlithography system 200 comprises a control unit 250. The control unit 250 may be connected (not explicitly shown in Fig. 1A) to one or more components of the microlithography system 200. The control unit 250 may be connected to, and receive data (or input) from, the first position sensor 240a and the second position sensor 240b. Furthermore, the control unit 250 may be connected to the stage 220, or to a servo unit (not shown) configured to actuate a movement of the stage 220, to control the movement of the stage 220. The control unit 250 may be connected to, and control, the tool head 230 and/or the optical beam scanning arrangement. In this way the control unit 250 may control the direction of the optical beam onto the substrate 210, for example based on data received from the first position sensor 240a and/or the second position sensor 240b.

In Fig. 1B, a schematic illustration of a microlithography system 200 configured to write a pattern on a substrate 210, in accordance with a second aspect of the present disclosure, is shown in top view. The substrate 210 is arranged in a plane defined by a first axis Y and a second axis X as in Fig. 1A. The first axis Y and second axis X are orthogonal and spans a writing coordinate system.

In Fig. 1B, the microlithography system 200 comprises a stage 220 configured to support the substrate 210 (as in Fig. 1A). Thus, the substrate 210 is placed on the stage 220 in the writing coordinate system. In Fig. 1B, the stage 220 is illustrated as a platform or a plate, however, the stage 220 may be formed differently, e.g., as a holder. In Fig. 1B, the stage is movable in a direction parallel with the first axis Y, e.g., a first direction D1. The microlithography system 200 in Fig. 1B comprises a tool head 230 which is movably arranged on a bridge 270. The bridge 270 is fixedly arranged in the microlithography system 200. For example, the bridge 270 may be attached or mounted to a base stone 260 comprised in the microlithography system 200 as seen in Fig. 1B. The stage 220 may be arranged on the base stone 260. The tool head 230 in Fig. 1B is movable in a direction parallel with the second axis X, e.g., a scanning direction S2. A relative motion between the tool head 230 and the stage 220 in the scanning direction S2 is provided. Since the stage 220 may move in the first direction D1, a relative motion between the tool head 230 and the stage 220 in the first direction D1 is also provided.

The tool head 230 comprises an optical beam scanning arrangement (not shown) configured to direct an optical beam (not shown) onto the substrate 210. During a writing process, the tool head in Fig. 1B may move along the scanning direction S2 and the stage 220 may move along the first direction D1, simultaneously or one at the time. Thereby, different parts of the substrate 210 may be exposed to the optical beam, and thus, a pattern may be created. In an example, during a writing process the stage 220 may move to a first predetermined position along the first direction D1. When the stage 220 has reached that first predetermined position along the first direction D1, the tool head 230 may move along the scanning direction S2 while writing. The stage 220 may then move to a second predetermined position along the first direction D1 and at that second predetermined position along the first direction D1, the tool head may move along the scanning direction S2 while writing. This may be repeated until a complete pattern is written on the substrate 210.

In Fig. 1B, the microlithography system 200 comprises a first position sensor 240a and a second position sensor 240b. The first position sensor 240a is configured to measure a position, and/or a position deviation, of the tool head 230 relative the stage 220 in the first direction D1, as illustrated with the dotted lines in Fig. 1B. The second position sensor 240b is configured to measure a position of the tool head 230 relative the stage 220 in the scanning direction S2, as illustrated with the dotted lines in Fig. 1B.

As shown in Fig. 1B, the microlithography system 200 comprises a control unit 250. The control unit 250 may be connected (not explicitly shown in Fig. 1B) to one or more components of the microlithography system 200. The control unit 250 may be connected to, and receive data (or input) from, the first position sensor 240a and the second position sensor 240b. Furthermore, the control unit 250 may be connected to the stage 220, or to a servo unit (not shown) configured to actuate a movement of the stage 220, to control the movement of the stage 220. The control unit 250 may be connected to, and control, the tool head 230 and/or the optical beam scanning arrangement. In this way the control unit 250 may control the movement of the tool head 230 in the scanning direction S2 and the direction of the optical beam onto the substrate 210, for example based on data received from the first position sensor 240a and/or the second position sensor 240b.

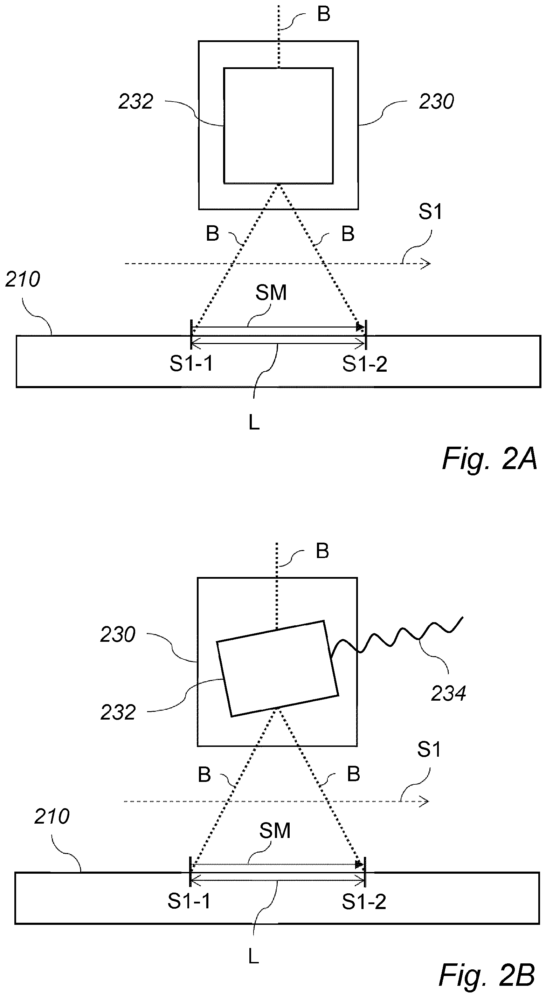

Figs. 2A and 2B schematically illustrates examples of a sweeping motion SM performed by an optical beam scanning arrangement 232 in accordance with some embodiments of the present disclosure.

In Fig. 2A, a schematic illustration of an example of a sweeping motion SM performed by an optical beam scanning arrangement 232 in accordance with some embodiments of the present disclosure is shown in side view.

In Fig. 2A, the tool head 230 comprises the optical beam scanning arrangement 232. The optical beam scanning arrangement 232 in Fig. 2A comprises at least one mirror, at least one optical polygon, and/or at least one prism. The optical beam scanning arrangement 232 is configured to direct (or deflect) an optical beam B in a sweeping motion SM in a sweep direction S1 onto a substrate 210. The at least one mirror, the at least one optical polygon, and/or the at least one prism comprised in the optical beam scanning arrangement 232 may perform a sweeping motion SM of the optical beam B. In other words, a microsweep may be performed on the substrate 210. The optical beam scanning arrangement 232 may be configured to receive input or data and control a sweeping motion SM based on the input or data, e.g., in order to perform a first compensation of the sweeping motion SM. In an example, the optical beam scanning arrangement 232 may comprise a rotatably arranged optical polygon. The optical polygon may be configured to rotate to perform a sweeping motion SM of the optical beam B in the sweeping direction S1. In an example, the optical beam scanning arrangement 232 may comprise a movable mirror. The mirror may be configured to be tilted or angled such that a sweeping motion SM of the optical beam B in the sweeping direction S1 is generated.

In Fig. 2A, the sweeping motion SM is illustrated with a solid arrow and the sweeping direction S1 is illustrated with a dashed arrow. The optical beam B being emitted on the substrate is illustrated with dotted lines. The optical beam scanning arrangement 232 receives the optical beam B and then directs it onto the substrate 210. As seen in Fig. 2A, the sweeping motion SM of the optical beam B starts at a first position S1-1 and ends at a second position S1-2. The dotted lines in Fig. 2A from the optical beam scanning arrangement 232 onto the substrate 210 represent the movement of the optical beam B during a sweeping motion SM from the first position S1-1 to the second position S1-2. The sweeping motion SM may have a speed which is kept constant. Thus, the optical beam B may move from the first position S1-1 to the second position S1-2 with a constant speed. As shown in Fig. 2A, the sweeping motion SM have a length L. The length L of the sweeping motion SM may be predetermined or pre-calibrated. The length L may be based on, e.g., the size of the pattern to be written, a predetermined number of pixels and/or a pixel size. The length L of the sweeping motion may be the distance between the first position S1-1 and the second position S1-2 as seen in Fig. 2A.

In Fig. 2B, a schematic illustration of an example of a sweeping motion SM performed by an optical beam scanning arrangement 232 in accordance with some embodiments of the present disclosure is shown in side view.

In Fig. 2B, the tool head 230 comprises the optical beam scanning arrangement 232 comprising an acousto-optical deflector. The acousto-optical deflector will be referred to with reference number 232 in regards to Fig. 2B. The acousto-optical deflector 232 is configured to direct (or deflect) an optical beam B in a sweeping motion SM in a sweep direction S1 onto a substrate 210. The acousto-optical deflector 232 may generate a sweeping motion SM of the optical beam B. In other words, a microsweep may be performed on the substrate 210.

As seen in Fig. 2B, the acousto-optical deflector 232 receives an input signal 234, e.g., from a control unit (not shown) comprised in the microlithography system (not shown). The input signal 234 may indicate an adjustment (or correction) of the sweeping motion SM of the optical beam B. Thus, the input signal 234 may, for example, control the direction (or deflection) of the optical beam B onto the substrate 210. The input signal 234 may be based on, e.g., a measured position deviation by at least one position sensor (not shown) of the microlithography system. The acousto-optical deflector 232 may be controlled by an acoustic frequency and/or an acoustic amplitude communicated via the input signal 234. The acoustic frequency may control the deflection of the optical beam B. By varying the acoustic frequency, the optical beam B may be deflected to different angular positions. Thus, the movement of the optical beam B in a sweeping motion SM may for example be adjusted by an acoustic frequency of the input signal 234. The acoustic amplitude may control the intensity of the optical beam B. By varying the acoustic amplitude, the intensity of the optical beam B in a sweeping motion may be varied. This may for example be used to achieve an even intensity over a microsweep. The intensity may, in turn, affect the pixel size, e.g., the width, of a microsweep.

In Fig. 2B, the sweeping motion SM is illustrated with a solid arrow and the sweeping direction S1 is illustrated with a dashed arrow. The optical beam B is illustrated with dotted lines in Fig. 2B. The acousto-optical deflector 232 receives the optical beam B and then directs it onto the substrate 210. As seen in Fig. 2B, the sweeping motion SM of the optical beam B starts at a first position S1-1 and ends at a second position S1-2. The dotted lines in Fig. 2A from the acousto-optical deflector 232 onto the substrate 210 represent the movement of the optical beam B during a sweeping motion SM from the first position S1-1 to the second position S1-2. The sweeping motion SM from the first position S1-1 to the second position S1-2 may be controlled (or based on) the acoustic frequency communicated via the input signal 234. As shown in Fig. 2B, the sweeping motion has a length L. The length L may be adjusted (or controlled) by the acoustic frequency controlling the deflection of the optical beam B. In an example, the acoustic frequency of the acousto-optical deflector 232 may be varied within a range, thereby causing the optical beam B to move, e.g., a distance (i.e., the length L) corresponding to the acoustic frequency range. The optical beam B may move in a sweeping motion SM in the sweep direction S1, e.g., a distance corresponding to the length L indicated by the acoustic frequency range.

As described with respect to Fig. 2A, the length L of the sweeping motion SM in Fig. 2B may be predetermined or pre-calibrated and may be based on, e.g., the size of the pattern to be written, a predetermined number of pixels and/or a pixel size. The sweeping motion SM in Fig. 2B may have a speed which is kept constant. Thus, the optical beam B may move from the first position S1-1 to the second position S1-2 with a constant speed.

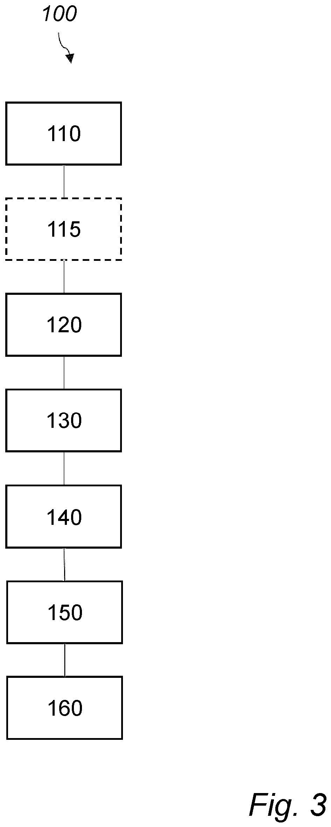

In Fig. 3, a flow diagram of a method 100 to compensate for a non-orthogonal sweeping motion in accordance with some embodiments of the present disclosure is illustrated. The method 100 may be performed or used in a microlithography system in accordance with any embodiment of the present disclosure. The microlithography system may for example be one of the microlithography systems illustrated in Figs. 1A-1B and Figs. 2A-2B. As an example, the method 100 will hereinafter be described with reference to the microlithography system in Fig. 1A. Furthermore, it is hereby referred to Figs. 1A-1B, Figs. 2A-2B and the associated texts for an increased understanding of the features of the microlithography system.

In Fig. 3, the method 100 comprises measuring 110 a position deviation of a tool head relative a stage in a first direction parallel with a first axis. Measuring 110 a position deviation of a tool head relative a stage in a first direction may comprise measuring a position of the tool head in the first direction and/or a position of the stage in the first direction. With reference to Fig. 1A, the first position sensor 240a measures a position deviation of the tool head 230 relative the stage 220 in the first direction D1 parallel with the first axis Y. The first position sensor 240a may measure a position of the tool head 230 in the first direction D1 and a position of the stage 220 in the first direction D1, and then determine a position deviation based on the measured positions. The first position sensor 240a may be configured to perform measurements relate to a position deviation continuously during a writing process.

In Fig. 3, the method 100 comprises receiving 115 a position deviation from at least one position sensor. With reference to Fig. 1A, the control unit 250 may be connected to the first position sensor 240a and configured to receive a measured position deviation from the first position sensor 240a. The control unit 250 may receive a measured position deviation from the first position sensor 240a continuously in real time, such as, during a writing process.

In Fig. 3, the method 100 comprises receiving 120 a sweep command comprising a sweep angle. The sweep angle is the angle between a sweep direction and the first direction. With reference to Fig. 1A, the control unit 250 is configured to receive a sweep command. The sweep command may be based on, e.g., input from a user of the microlithography system 200 or predetermined (or stored) data in, e.g., a control unit 250 of the microlithography system. In an example, a user may input a sweep angle such that a sweep command may be generated and communicated to the control unit 250. The sweep angle may be selected (or chosen) depending on a pattern to be generated on a substrate 210 or an application of the microlithography system 200.

In Fig. 3, the method 100 comprises determining 130 an X-offset in a scanning direction based on the position deviation and the sweep angle. With respect to Fig. 1A, the control unit 250 is configured to determine (or calculate) the X-offset in the scanning direction. The control unit 250 may calculate the X-offset based on a measured position deviation in the first direction D1 from the first position sensor 240a and the sweep angle received in a sweep command.

In Fig. 3, the method 100 comprises performing 140 a first compensation of the sweeping motion of an optical beam scanning arrangement based on the position deviation and the sweep angle. The first compensation may be applied in the optical beam scanning arrangement. The first compensation may be applied along the sweep direction. With reference to Fig. 1A, the control unit 250 may determine a sweep deviation in the sweep direction based on a measured position deviation in the first direction D1 by the first position sensor 240a and the sweep angle comprised in a received sweep command. The first compensation may comprise applying the sweep deviation to the optical beam scanning arrangement to adjust the sweeping motion in the sweep direction.

The optical beam scanning arrangement may be configured to receive an input signal, e.g., from a control unit. Performing 140 the first compensation of the sweeping motion of the optical beam scanning arrangement may comprise adjusting an input signal to the optical beam scanning arrangement based on the position deviation and the sweep angle. The sweeping motion may be controlled at least partially based on the input signal. In an example, a calculate sweep deviation may be communicated to the optical beam scanning arrangement via the input signal.

In Fig. 3, the method 100 comprises performing 150 a second compensation of the sweeping motion by moving the tool head and/or the stage in the scanning direction based on the X-offset. The second compensation may be performed based on the determined X-offset. With reference to Fig. 1A, the second compensation is performed by movement of the tool head 230 and/or the stage 220 in the scanning direction S2. The determined X-offset may correspond to a distance in the scanning direction S2. The second compensation may thus comprise moving the tool head 230 and/or the stage 220 a distance corresponding to the X-offset. In an example with reference to Fig. 1A, the tool head 230 and/or the stage 220 may move with a velocity in the scanning direction S2. A determined X-offset corresponding to a distance in the scanning direction S2 may correspond to a time delay based on the velocity. A start of a sweeping motion may be based on the time delay. In Fig. 3, performing 150 a second compensation may constitute performing a time delay corresponding to the X-offset.

The method 100 may comprise moving the tool head and/or the stage with a constant (or fixed) velocity in the scanning direction. A determined X-offset corresponding to a distance in the scanning direction may thus correspond to a time delay based on the constant velocity.

In Fig. 3, the method 100 comprises performing 160 the sweeping motion in the sweep direction wherein the sweep direction is non-orthogonal to the first axis and the second axis, respectively. After or simultaneously as performing 140 the first compensation and/or performing 150 the second compensation, the sweeping motion in the sweep direction may be performed. The first compensation in the sweep direction and the second compensation in the scanning direction may be performed simultaneously in real time during a writing process.

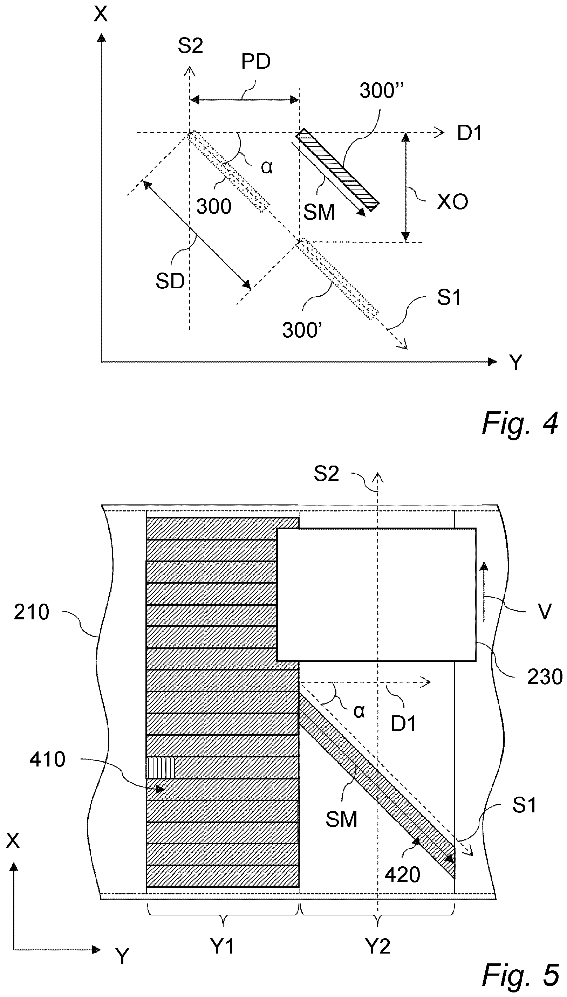

In Fig. 4, a compensation for a non-orthogonal sweeping motion SM in accordance with some embodiments of the present disclosure is schematically illustrated. In Fig. 4, a first axis Y and a second axis X are shown. The first axis Y and the second axis X in Fig. 4 correspond to the first axis Y and the second axis X shown in Figs. 1A and 1B. In Fig. 4, the first direction D1, the sweep direction S1 and the scanning direction S2 are illustrated with dashed arrows. A measured position deviation PD in the first direction D1 is illustrated with a double arrow in Fig. 4. A sweep angle α is shown in Fig. 4, wherein the sweep angle α is the angle between the sweep direction S1 and the first direction D1. The sweep angle α may fulfill the condition 0° < α < 90°. In an example, the sweep angle α may be 45° (45 degrees).

In Fig. 4, a first position 300 of a microsweep, a second position 300' of a microsweep and a third position 300" of a microsweep are shown. The first position 300 and the second position 300' of a microsweep are illustrated as dotted microsweeps in Fig. 4 since these correspond to theoretical positions of a microsweep before a first compensation and a second compensation of a sweeping motion SM have been performed. The third position 300" of a microsweep is illustrated as a microsweep with a solid outline and striped fill since this correspond to the position of the microsweep after a first compensation and a second compensation of a sweeping motion SM have been performed.

Based on the position deviation PD and the sweep angle α, a sweep deviation SD in the sweep direction S1 may calculated, e.g., using trigonometry. The sweep deviation SD is illustrated with a double arrow in Fig. 4. The calculated sweep deviation SD may be applied to the optical beam scanning arrangement (not shown) to perform a first compensation of the sweeping motion SM in the sweep direction S1. As seen in Fig. 4, the calculated sweep deviation SD corresponds to a distance that the sweeping motion SM is adjusted or moved in the sweep direction S1. Performing the first compensation of the sweeping motion SM may comprise adjusting the sweeping motion SM in the optical beam scanning arrangement a distance corresponding to the sweep deviation SD in the sweep direction S1. In Fig. 4, this is illustrated as moving the microsweep from the first position 300 of the microsweep to the second position 300' of the microsweep.

Based on the position deviation PD and the sweep angle α, an X-offset XO in the scanning direction S2 may calculated, e.g., using trigonometry. The X-offset XO is illustrated with a double arrow in Fig. 4. The calculated X-offset XO may be applied to the tool head (not shown) and/or the stage (not shown) to perform a second compensation of the sweeping motion SM in the scanning direction S2. As seen in Fig. 4, the calculated X-offset XO corresponds to a distance that the sweeping motion SM is adjusted or moved in the scanning direction S2. Performing the second compensation of the sweeping motion SM may comprise moving the tool head and/or the stage in the scanning direction S2 based on the X-offset. In Fig. 4, this is illustrated as moving the microsweep from the second position 300' of the microsweep to the third position 300" of the microsweep. In an example, the stage may move in the scanning direction S2 with a velocity. The X-offset, illustrated in Fig. 4 as a distance, may correspond to a time delay given the velocity of the stage. The start of the sweeping motion SM may be based on the time delay.

Thereby, after performing the first compensation of the sweeping motion SM in the sweep direction S1 and performing the second compensation of the sweeping motion SM in the scanning direction S2, the sweeping motion SM may be performed. Thus, as illustrated in Fig. 4, the microsweep may be performed at the third position 300" of the microsweep.

In Fig. 4, the sweep direction S1 is non-orthogonal to the first axis Y and the second axis X, respectively. The sweeping motion SM in the sweep direction S1 is thereby a non-orthogonal sweeping motion SM. The performed microsweep at the third position 300" of the microsweep is thus non-orthogonal to the first axis Y and the second axis X, respectively.

In Fig. 5, a schematic illustration of an example writing process of a substrate 210 comprising a non-orthogonal sweeping motion SM in accordance with some embodiments of the present disclosure is shown in top view. In Fig. 5, an example of an ongoing writing process of a part of a substrate 210 is shown. In Fig. 5, a first axis Y and a second axis X are illustrated. The first axis Y and the second axis X in Fig. 5 correspond to the first axis Y and the second axis X shown in Figs. 1A, 1B and 4. A sweep direction S1 and a scanning direction S2 are illustrated as dashed arrows in Fig. 5.

In Fig. 5, a first scan strip Y1 and a second scan strip Y2 are illustrated. As seen in Fig. 5, the first scan strip Y1 comprises a plurality of microsweeps 410, wherein each microsweep of the plurality of microsweeps is orthogonal to the second axis X and parallel to the first axis Y. In Fig. 5, a tool head 230 is shown in the second scan strip Y2. In an example, the tool head 230 in Fig. 5 may have performed the plurality of microsweeps 410 in the first scan strip and then continued writing in the second scan strip Y2 to continue the writing process of the substrate 210. After completing the first scan strip Y1, the stage (not shown), on which the substrate 210 may be arranged, may move in a direction parallel with the first axis Y to the second scan strip Y2. The tool head 230 and/or the stage may move in the scanning direction S2. The velocity V shown in Fig. 5 illustrate the relative velocity between the tool head 230 and the stage. The velocity V may be constant. In the second scan strip Y2, the optical beam scanning arrangement (not shown) comprised in the tool head 230 has performed a non-orthogonal sweeping motion SM of the optical beam in the sweep direction S1. Thereby, as seen in Fig. 5, a microsweep 420 has been performed. The sweep direction S1 is directed at a sweep angle α to the first direction D1 as shown in Fig. 5.

The person skilled in the art realizes that the present invention by no means is limited to the preferred embodiments described above. On the contrary, many modifications and variations are possible within the scope of the appended claims.

Although features and elements are described above in particular combinations, each feature or element can be used alone without the other features and elements or in various combinations with or without other features and elements.

Additionally, variations to the disclosed embodiments can be understood and effected by the skilled person in practicing the claimed invention, from a study of the drawings, the disclosure, and the appended claims. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. A method (100) to perform a non-orthogonal sweeping motion in a microlithography system configured to write a pattern on a substrate arranged in a plane defined by a first axis and a second axis, wherein the second axis is orthogonal to the first axis, wherein the microlithography system comprises a stage configured to support the substrate and a tool head comprising an optical beam scanning arrangement configured to direct an optical beam in a sweeping motion in a sweep direction, and wherein the tool head and/or the stage is movable to provide relative motion between the tool head and the stage in a scanning direction parallel with the second axis, the method comprising:
measuring (110) a position deviation of the tool head relative the stage in a first direction parallel with the first axis,
receiving (120) a sweep command comprising a sweep angle, α, wherein the sweep angle is an angle between the sweep direction and the first direction,
determining (130) an X-offset in the scanning direction, based on the position deviation and the sweep angle,
performing (140) a first compensation of the sweeping motion of the optical beam scanning arrangement based on the position deviation and the sweep angle,
performing (150) a second compensation of the sweeping motion by moving the tool head and/or the stage in the scanning direction based on the X-offset,
performing (160) the sweeping motion in the sweep direction wherein the sweep direction is non-orthogonal to the first axis and the second axis, respectively.

2. The method according to claim 1, wherein the microlithography system further comprises at least one position sensor, wherein the at least one position sensor is configured to measure a position deviation of the tool head relative the stage in the first direction, and wherein the method further comprises receiving (115) the position deviation from the at least one position sensor.

3. The method according to claim 2, wherein the at least one position sensor comprises an interferometer.

4. The method according to any one of the preceding claims, wherein the optical beam scanning arrangement comprises at least one mirror, at least one optical polygon, and/or at least one prism.

5. The method according to any one of the preceding claims, wherein the optical beam scanning arrangement comprises an acousto-optical deflector.

6. The method according to claim 5, wherein performing a first compensation of the sweeping motion of the optical beam scanning arrangement comprises adjusting (145) an input signal to the acousto-optical deflector based on the position deviation and the sweep angle, such that the sweeping motion is controlled at least partially based on the input signal.

7. The method according to claim 6, wherein adjusting the input signal comprises adjusting at least one of an acoustic frequency and an acoustic amplitude of the acousto-optical deflector based on the position deviation and the sweep angle.

8. The method according to any one of the preceding claims, wherein a speed of the sweeping motion in the sweeping direction is kept constant.

9. The method according to any one of the preceding claims, wherein a length of the sweeping motion in the sweeping direction is predetermined.

10. The method according to any one of the preceding claims, wherein the method further comprises moving the tool head and/or the stage with a constant velocity in the scanning direction.

11. The method according to any one of the preceding claims, wherein the X-offset corresponds to a time delay, and wherein a start of the sweeping motion is based on the time delay.

12. The method according to any one of the preceding claims, wherein the sweep angle, α, is 45 degrees.

13. The method according to any one of the preceding claims, wherein the sweep angle, α, fulfills 0° < α < 90°.

14. A microlithography system (200) configured to write a non-orthogonal sweeping motion on a substrate (210) arranged in a plane defined by a first axis and a second axis wherein the second axis is orthogonal to the first axis, wherein the microlithography system comprises:
a stage (220) configured to support the substrate,
a tool head (230) comprising an optical beam scanning arrangement (232) configured to direct an optical beam in a sweeping motion in a sweep direction and wherein the tool head and/or the stage is movable to provide relative motion between the tool head and the stage in a scanning direction parallel with the second axis,
at least one position sensor (240) configured to measure a position deviation of the tool head relative the stage in a first direction parallel with the first axis,
a control unit (250) configured to receive a sweep command comprising a sweep angle, α, wherein the sweep angle is an angle between the sweep direction and the first direction, and wherein the control unit is configured to determine an X-offset in the scanning direction based on the position deviation and the sweep angle,
wherein the control unit is configured to control the optical beam scanning arrangement by applying a first compensation based on the position deviation and the sweep angle, and wherein the control unit is configured to control the movement of the tool head and/or the stage by applying a second compensation based on the X-offset, and
wherein the control unit is configured to control a sweeping motion in the sweep direction wherein the sweep direction is non-orthogonal to the first axis and the second axis, respectively.

15. The microlithography system according to claim 14, wherein the microlithography system is configured to perform a plurality of sweeping motions in sequence, wherein the plurality of sweeping motions comprises at least one non-orthogonal sweeping motion.
